# EUROPEAN PATENT APPLICATION

(11) **EP 1 740 026 A2**
(43) Date of publication of application: **03.01.2007**
(21) Application number: 05255946.5
(22) Date of filing: 23.09.2005
(51) Int. Cl.: H05K 3/26, B08B 7/02, H01L 21/60

(54) **Foreign matter removing apparatus**

(30) Priority: 27.06.2005 JP 2005186145
(71) Applicant: FUJITSU LIMITED, Kawasaki-shi, Kanagawa 211-8588 (JP)
(72) Inventor: Suehiro, Mitsuo, c/o Fujitsu Limited, Kawasaki-shi, Kanagawa 211-8588 (JP)
(74) Representative: Fenlon, Christine Lesley

(57) **Abstract**

A foreign matter removing apparatus (1) which removes foreign matter existing on a mounting surface (11) of a printed board unit (10). The foreign matter removing apparatus (1) includes a holder (14) which holds the printed board unit (10) in its desired attitude, an electromagnetic vibrator (15) which generates a continuous shock wave having repeated waveform, and a transmitting plate (12) which transmits the continuous shock wave generated by the electromagnetic vibrator(15) to the printed board unit (10) held by the holder (14).

## Description

### BACKGROUND OF THE INVENTION

### 1. Field of the Invention

The present invention relates to a foreign matter removing apparatus for removing foreign matter on a mounting surface of a printed board unit.

### 2. Description of the Related Art

Conventionally, various methods for removing foreign matter such as dust attached to an electronic device by means of vibration are devised. For example, there is disclosed a dust removing method (see Japanese Patent Application Laid-open No.58-61543 (pages 1 to 2, Fig. 7) for example) in which an inclination angle of a cathode-ray tube is variously changed while vibrating an outer wall of a cathode-ray tube by a vibration generator, thereby removing foreign matter existing in a gap of obstruction such as a shadow mask in the cathode-ray tube.

There is also disclosed a wafer chuck (see Japanese Patent Application Laid-open No.2000-195930 (pages 1 to 3, Fig. 1) for example) in which a chuck itself has a function for cleaning, using ultrasonic vibration, the chuck surface on which a wafer is placed in a semiconductor producing apparatus.

In the case of a printed board unit having a surface on which parts are mounted, however, the mounted parts become bumps when foreign matter is removed. Thus, in the case of the methods disclosed in the documents described above, foreign matter can not be removed sufficiently, and a foreign matter removing apparatus suitable for the printed board unit is desired.

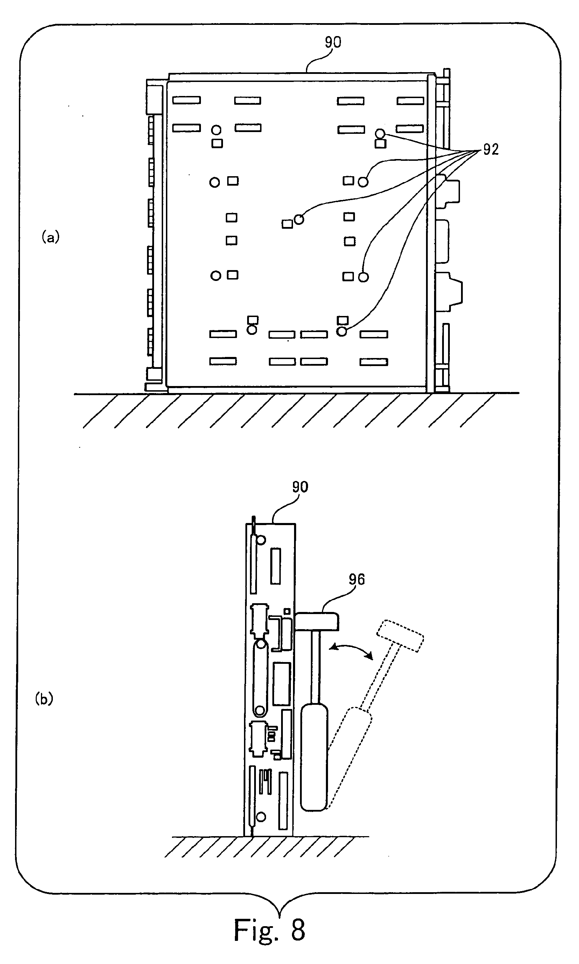

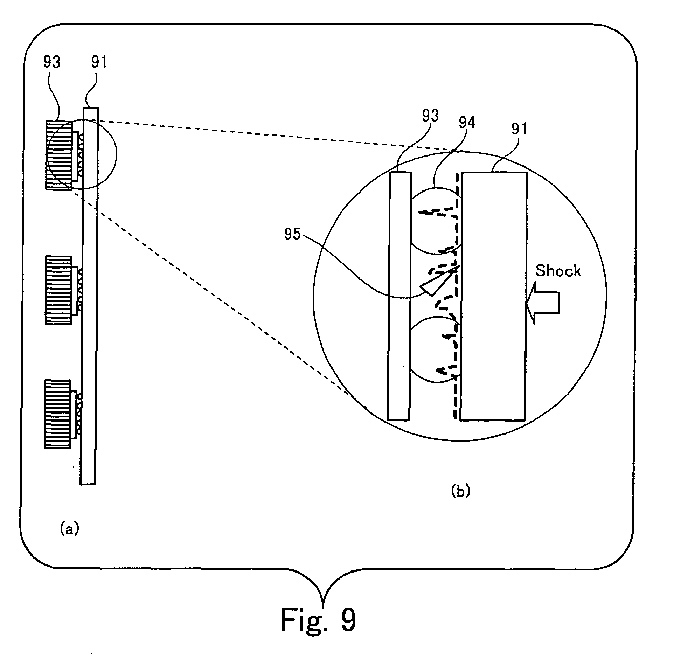

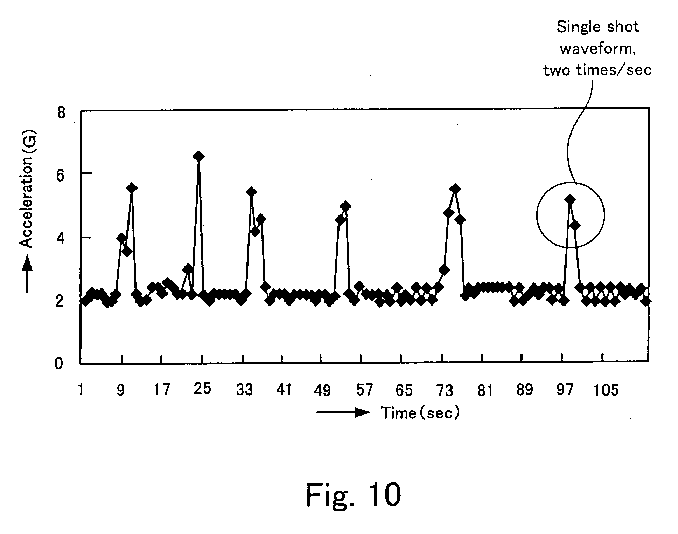

Fig. 8 is a schematic diagram showing a foreign matter removing method of a conventional printed board unit, Fig. 9 is an explanatory view of a problem in the foreign matter removing method shown in Fig. 8, and Fig. 10 is a waveform diagram of shock wave in the foreign matter removing method of a conventional printed board unit.

As shown in Figs. 8 to 10, according to this foreign matter removing method, a striking which can apply shock wave of single waveform of about 5G acceleration two times per second is repeated thousands times on shock effective points 92 on a printed board 91 of a printed board unit 90 using a hammer 96, thereby removing foreign matter 95 entering a gap of mounted parts mounted on the printed board unit 90.

However, BGA (Ball Grid Array) 93 is included in the mounted parts of the printed board unit, and input/output terminal bumps 94 of the BGA 93 are disposed on the printed board unit at extremely narrow pitch and various patterns (normal/zigzag/random). Therefore, foreign matter 95 entering between the bumps 94 can not sufficiently be removed even if thousands repeated shocks by a hammer 96 and foreign matter remains in some cases. When the remaining foreign matter 95 is conductive foreign matter, short-circuit is generated between the terminals and thus, such printed board unit is discarded as failure part.

According to the foreign matter removing method using such shock wave, excessive shock exceeding shock resistance is applied to the printed board unit and there is a danger that the printed board unit itself is destroyed, and there is a problem that defectives are frequently produced in a screening stage during which latent failure of the printed board unit such as production failure and element failure of the printed board unit is removed.

Hence, a previously-proposed foreign matter removing method uses an air blow or vacuum instead of the foreign matter removing method using the shock wave.

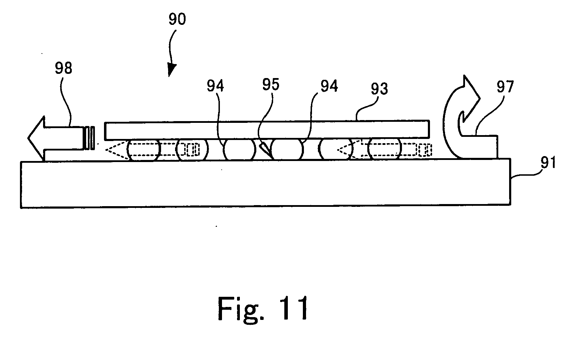

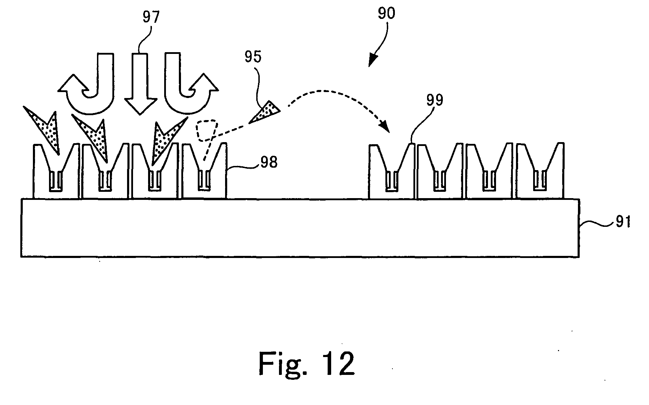

Fig. 11 is a schematic diagram of a foreign matter removing method utilizing air blow and vacuum, and Fig. 12 is a diagram showing a problem in the foreign matter removing method shown in Fig. 11.

As shown in Fig. 11, according to this foreign matter removing method, foreign matter 95 entering between the printed board 91 of the printed board unit 90 and the bumps 94 of the BGA 93 is removed using air flow caused by an air blow 97 and a vacuum 98.

According to this method, however, air flow does not reach a central portion in the BGA 93 and foreign matter 95 can not be removed completely unless the air pressure of the air blow 97 or the suction pressure of the vacuum 98 is extremely increased.

As shown in Fig. 12, there is a problem that foreign matter 95 attached to a connector 98 mounted on the printed board 91 of the printed board unit 90 is scattered by the air blow 97 and enters into another part such as a connector 99, and this causes short-circuit between terminals.

### SUMMARY OF THE INVENTION

Accordingly, it is desirable to provide a foreign matter removing apparatus capable of effectively removing foreign matter existing on a mounting surface of a printed board unit.

A foreign matter removing apparatus according to an embodiment of the present invention is an apparatus which removes foreign matter existing on a mounting surface of a printed board unit having parts mounted on the mounting surface, the foreign matter removing apparatus including:
a holder which holds the printed board unit in its desired attitude,
a shock wave generator which generates continuous shock wave having repeated waveform, and
a transmitting member which transmits continuous shock wave generated by the shock wave generator to the printed board unit held by the holder.

According to the foreign matter removing apparatus embodying the invention, continuous shock wave is applied to the printed board unit in a state in which the printed board unit is held at its desired attitude. With this, it is possible to effectively remove foreign matter existing on the mounting surface of the printed board unit.

Here, it is preferable that the shock wave generator is an electromagnetic vibrator.

If the foreign matter removing apparatus of the invention has the above structure, it is possible to realize a foreign matter removing apparatus having excellent operability and maintenance performance.

It is preferable that the holder holds the mounting surface downwardly.

If the foreign matter removing apparatus of the invention has the above structure, it is possible to effectively remove foreign matter entering into a connector mounted on the printed board unit.

It is preferable that the apparatus further includes a blower which blows gas toward the printed board unit.

If the foreign matter removing apparatus of the invention has the above structure, it is possible to enhance the foreign matter removing effect of the foreign matter removing apparatus.

It is preferable that the apparatus further includes a suction device which sucks gas from the printed board unit in addition to the blower.

If the foreign matter removing apparatus of the invention has the above structure, it is possible to enhance the foreign matter removing effect of the foreign matter removing apparatus.

It is preferable that the apparatus further includes a foreign matter collector which collects foreign matter included in gas sucked by the suction device.

If the foreign matter removing apparatus of the invention has the above structure, it is possible to obtain useful information for enhancing quality of the printed board unit by analyzing the collected foreign matter.

It is preferable that the apparatus further includes a sensor which measures intensity of shock received by the printed board unit from the continuous shock wave, and a monitoring unit which monitors a shock value measured by the sensor.

If the foreign matter removing apparatus of the invention has the above structure, since it is possible to easily monitor the intensity of shock received by the printed board unit, it is possible to prevent the printed board unit from being destroyed by excessive shock value.

According to an embodiment of the present invention, it is possible to realize a foreign matter removing apparatus capable of effectively removing foreign matter existing on a mounting surface of a printed board unit.

### BRIEF DESCRIPTION OF THE DRAWINGS

Fig. 1 illustrates a schematic view (a) and a partial enlarged view (b) showing an embodiment of a foreign matter removing apparatus of the invention;
Fig. 2 is a graph showing waveform of continuous shock wave applied to a printed board unit;
Figs. 3 (a) and 3 (b) are diagrams showing a shock position changing mechanism of the embodiment;
Fig. 4 illustrates a schematic view (a) showing a second embodiment of the foreign matter removing apparatus of the invention and an enlarged view (b) of collected foreign matter;
Fig. 5 illustrates a schematic view (a) showing a third embodiment of the foreign matter removing apparatus of the invention and a partial enlarged view (b) thereof;
Fig. 6 is a schematic diagram of a foreign matter removing apparatus of a fourth embodiment of the invention;
Fig. 7 is a graph showing a shock value monitoring result by the foreign matter removing apparatus shown in Fig. 6;
Fig. 8 is a schematic diagram showing a foreign matter removing method of a previously-proposed printed board unit;
Fig. 9 is an explanatory view of a problem in the foreign matter removing method shown in Fig. 8;
Fig. 10 is a waveform diagram of shock wave in the foreign matter removing method of a previously-proposed printed board unit;
Fig. 11 is a schematic diagram of a foreign matter removing method utilizing gas blow and vacuum; and
Fig. 12 is a diagram showing a problem in the foreign matter removing method shown in Fig. 11.

### DETAILED DESCRIPTION OF THE INVENTION

An embodiment of a foreign matter removing apparatus of the present invention will be explained below with reference to the drawings.

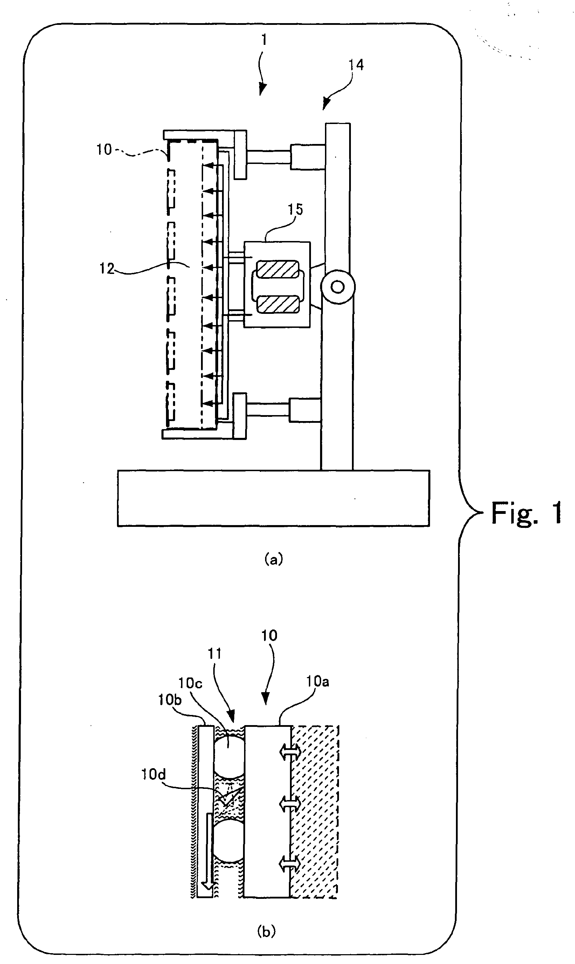

Fig. 1 illustrates a schematic diagram (a) showing an embodiment of the foreign matter removing apparatus of the invention, and a partially enlarged diagram (b) thereof.

As shown in Fig. 1, the foreign matter removing apparatus 1 removes foreign matter 10d existing on a mounting surface 11 (see part (b) of Fig. 1) of a printed board unit 10. The foreign matter removing apparatus 1 includes a holder 14 which holds the printed board unit 10 in a desired attitude, an electromagnetic vibrator 15 which generates continuous shock wave having repeated waveform, and a transmitting plate 12 which transmits the continuous shock wave generated by the shock wave generator 15 to the printed board unit 10 held by the holder 14.

The transmitting plate 12 of the embodiment corresponds to a transmitting member of the invention.

If the continuous shock wave is transmitted to the printed board unit 10 through the transmitting plate 12, the foreign matter 10d existing between a printed board 10a and a bump 10c of a BGA (Ball Grid Array) 10b drops downward by the continuous shock wave as shown with a long arrow in part (b) of Fig. 1.

The electromagnetic vibrator 15 of the embodiment corresponds to a shock wave generator of the invention. The shock wave generator is not limited to the electromagnetic vibrator, and any shock wave generator can be used only if it generates the continuous shock wave having repeated waveform, but it is preferable to use the electromagnetic vibrator in view of operability and maintenance performance.

In this embodiment, as shown in part (a) of Fig. 1, the printed board unit 10 is fixed in its inverted state by the holder 14 so that continuous shock wave generated by the electromagnetic vibrator 15 mounted on the printed board unit 10 on the opposite side from the mounting surface 11 is transmitted to the printed board unit 10 through the transmitting plate 12.

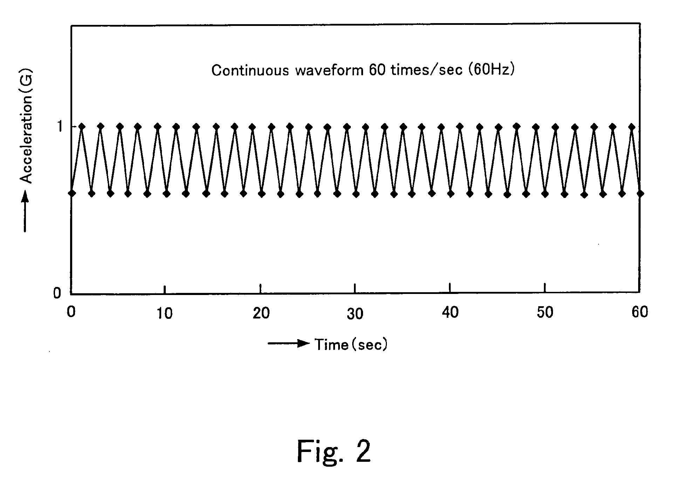

Fig. 2 is a graph showing waveform of the continuous shock wave applied to the printed board unit.

Fig. 2 shows a waveform of the continuous shock wave having repeated waveform of acceleration of about 0.7G and 60times/sec (60Hz).

Next, a result of a foreign matter removing effect confirmation test carried out using the continuous shock wave of the embodiment will be explained.

### (1) Product reliability enhancing effect by reducing influence caused by shock

The product reliability enhancing effect obtained by applying the electromagnetic vibrator shock as compared with a previously-proposed hammer stroke (see Fig. 8) is as follows:
• shock (G)

| | |
|---|---|
| Previously-proposed technique: | Ave 4.2, Max 6.7G |
| Present invention: | Ave 0.7, Max 1.0G |
| Effect: | AveΔ3.5G, Max Δ5.7G |

That is, according to an embodiment of the invention, about 1/6 shock (G) of the previously-proposed technique is sufficient, and it is estimated that the product reliability is enhanced by six times.
• Stress (µε)

| | |
|---|---|
| Previously-proposed technique: | Ave 25, Max 40 |
| Present invention: | Ave 8.0, Max 8.9 |
| Effect: | AveΔ17, Max Δ31.1 |

That is, according to an embodiment of the invention, stress (µε) is reduced to about 1/3 of the previously-proposed technique, and it is estimated that the product reliability is enhanced by three times.

### (2) Foreign matter removing time shortening effect

• Man-hour

| | |
|---|---|
| Previously-proposed technique: | 1.00h |
| Present invention: | 0.03h |
| Effect: | Δ0.97h |

That is, according to an embodiment of the invention, man-hour is reduced by 97% as compared with the previously-proposed technique, and it is estimated that the costs can largely be reduced.

As described above, according to the foreign matter removing apparatus of the embodiment, continuous shock wave having 30 times speed, 1/6 shock force and 1/3 stress as compared with the conventional hammer stroke is stably be supplied by the electromagnetic vibrator, and foreign matter such as dust existing on the printed board unit can effectively be removed.

According to the foreign matter removing apparatus embodying the invention, it is possible to reduce a danger that a printed board unit itself is destroyed by excessive shock exceeding the shock resistance that is a problem in a foreign matter removing method using the previously-proposed hammer stroke. Further, it is possible to overcome a problem that defectives are frequently produced in a screening stage during which failure of the printed board unit such as production failure and element failure of the printed board unit is removed.

It is possible to automatically carry out the foreign matter removing operation which is equivalent to thousands of strikings (single shot) using the previously-proposed hammer stroke within a short time as short as about 1/30 of the previously-proposed technique.

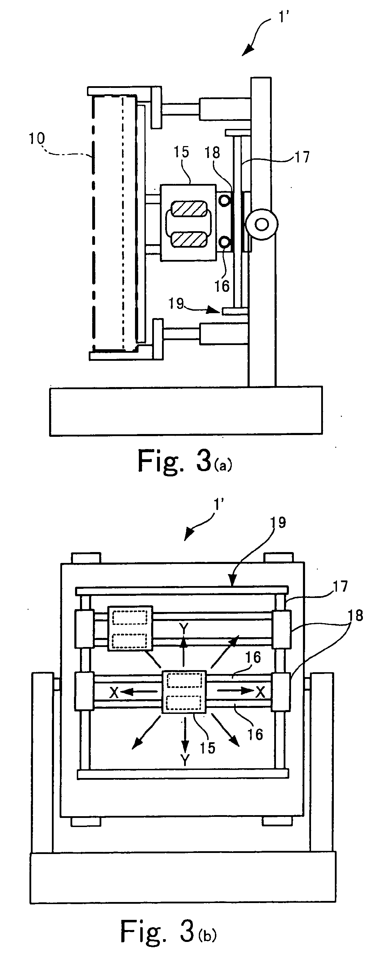

Fig. 3 shows a shock position changing mechanism of the embodiment.

As shown in Figs. 3 (a) (side view) and 3 (b) (front view), the foreign matter removing apparatus 1' includes a shock position changing mechanism 19. The shock position changing mechanism 19 includes an X-direction slide bar 16 which supports the electromagnetic vibrator 15 such that the electromagnetic vibrator 15 can move in the X-direction, a slide bearing 18 which supports the X-direction slide bar 16, and a Y-direction slide bar 17 which supports the slide bearing 18 such that the slide bearing 18 can move in the Y-direction.

The foreign matter removing apparatus 1' having the shock position changing mechanism 19 can freely change the shock position at which shock wave is supplied to the printed board unit 10 by the electromagnetic vibrator 15. Therefore, it is possible to efficiently remove foreign matter by moving the electromagnetic vibrator 15 to a shock position where foreign matter exists in the printed board unit 10 from which foreign matter is to be removed.

Next, a second embodiment of the invention will be explained.

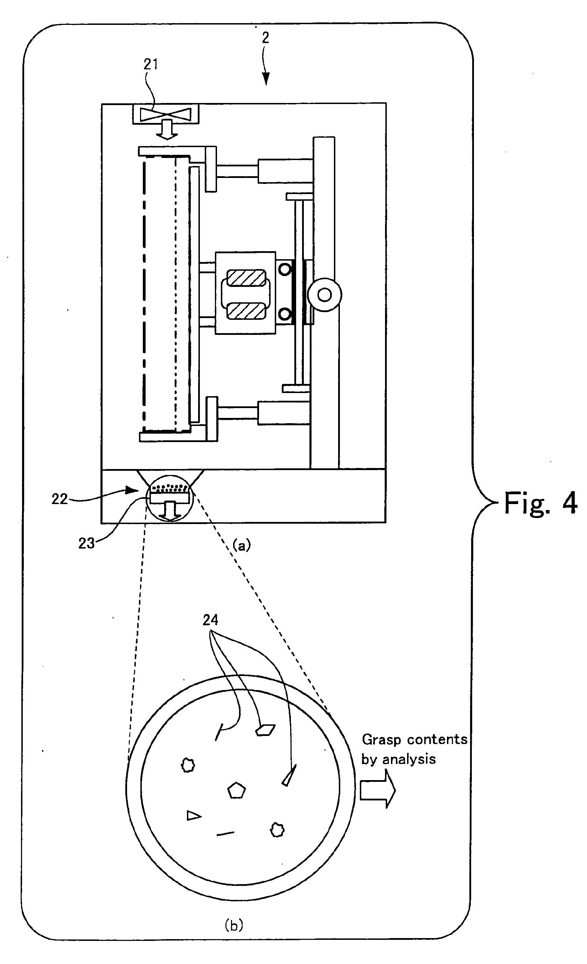

Fig. 4 illustrates a schematic diagram (a) showing the second embodiment of the foreign matter removing apparatus of the invention, and an enlarged view (b) of collected foreign matter.

As shown in part (a) of Fig. 4, the foreign matter removing apparatus 2 of the second embodiment includes a blowout fan unit 21 provided above the printed board unit 10 for blowing gas toward the printed board unit 10, and a vacuum unit 22 provided below the printed board unit 10 for sucking gas from the printed board unit 10. Foreign matter dropped by vibration is forcibly removed from the printed board unit 10 by the blowout fan unit 21 and the vacuum unit 22.

According to the second embodiment, the vacuum unit 22 is provided with a filter 23 for collecting foreign matter included in gas sucked by the vacuum unit 22, and the filter 23 can collect the dropped foreign matter 24 (see part (b) of Fig. 4). If the foreign matter 24 collected by the filter 23 is analyzed to grasp contents in the foreign matter 24, it is possible to obtain useful information for enhancing the quality of the printed board unit.

The blowout fan unit 21 corresponds to a blower of an embodiment of the invention, the vacuum unit 22 corresponds to a suction device of an embodiment of the invention, and the filter 23 corresponds to a foreign matter collector of an embodiment of the invention.

Next, a third embodiment of the invention will be explained.

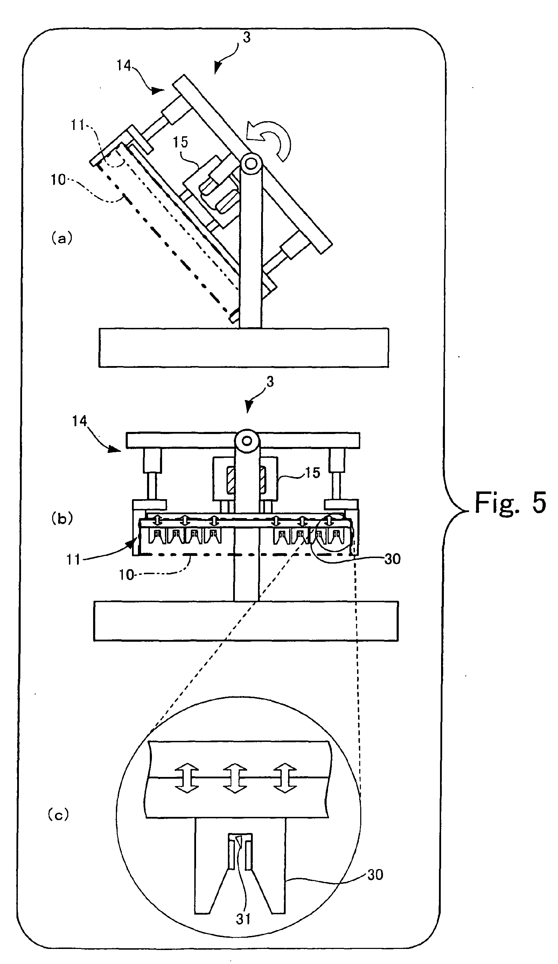

Fig. 5 illustrates a schematic diagram (a) showing a foreign matter removing apparatus of the third embodiment, and a partial enlarged view (b) thereof.

As shown in part (a) of Fig. 5, the holder 14 of the foreign matter removing apparatus 3 can hold the printed board unit 10 with any angle. As shown in part (b) of Fig. 5, continuous shock wave generated by the electromagnetic vibrator 15 is transmitted to the printed board unit 10 in a state in which the mounting surface 11 is held downwardly.

With this structure, as shown in part (c) of Fig. 5, the foreign matter 31 entered into a connector 30 mounted on the printed board unit 10 can effectively drop downward.

Next, a fourth embodiment of the invention will be explained.

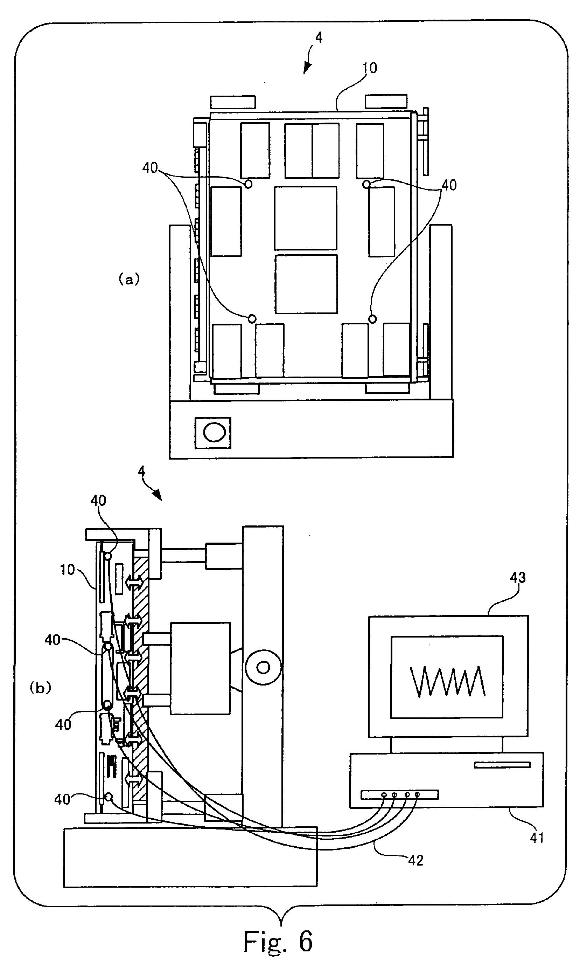

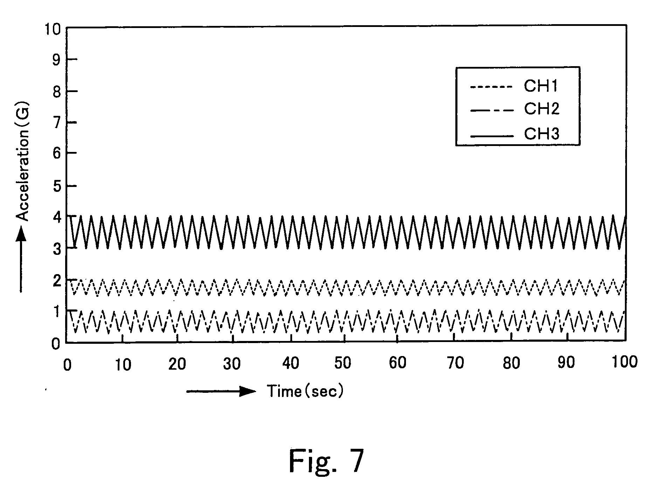

Fig. 6 shows an outline of a foreign matter removing apparatus of a fourth embodiment, and Fig. 7 is a graph showing a shock value monitoring result by the foreign matter removing apparatus shown in Fig. 6.

As shown in parts (a) and (b) of Fig. 6, the foreign matter removing apparatus 4 includes G sensors 40 which measure the intensity of shock received by various portions of the printed board unit 10 by continuous shock wave, a monitoring unit 41 which monitors shock values measured by the G sensors 40, cables 42 which transmit measuring signals from the G sensors 40 to the monitoring unit 41, and a display unit 43 which displays a monitoring result on a screen.

As shown in Fig. 7, acceleration G (intensity of shock) received by the various portions (CH1, CH2, CH3, ...) of the printed board unit 10 from the G sensors 40 and the monitoring unit 41 is displayed on the display unit 43. With this, it is possible to easily monitor the shock value received by the various portions of the printed board unit 10.

With the foreign matter removing apparatus 4 having such a structure, it is possible to effectively remove foreign matter existing on a mounting surface of the printed board unit without applying excessive shock to the printed board unit when a screening test is carried out at the time of shipping.

## Claims

1. A foreign matter removing apparatus which removes foreign matter existing on a mounting surface of a printed board unit having parts mounted on the mounting surface, the foreign matter removing apparatus comprising:
a holder which holds the printed board unit in its desired attitude,
a shock wave generator which generates continuous shock wave having repeated waveform, and
a transmitting member which transmits continuous shock wave generated by the shock wave generator to the printed board unit held by the holder.

2. The foreign matter removing apparatus according to claim 1, wherein the shock wave generator is an electromagnetic vibrator.

3. The foreign matter removing apparatus according to claim 1 or 2, wherein the holder holds the mounting surface downwardly.

4. The foreign matter removing apparatus according to claim 1, 2 or 3, further comprising a blower which blows gas toward the printed board unit.

5. The foreign matter removing apparatus according to claim 4, further comprising a suction device which sucks gas from the printed board unit.

6. The foreign matter removing apparatus according to claim 5, further comprising a foreign matter collector which collects foreign matter included in gas sucked by the suction device.

7. The foreign matter removing apparatus according to any preceding claim, further comprising a sensor which measures intensity of shock received by the printed board unit from the continuous shock wave, and a monitoring unit which monitors a shock value measured by the sensor.
